# EUROPÄISCHE PATENTSCHRIFT

(11) **EP 2 568 508 B1**
(45) Veröffentlichungstag und Bekanntmachung des Hinweises auf die Patenterteilung: **31.08.2016**
(21) Anmeldenummer: 12191953.4
(22) Anmeldetag: 12.06.2008
(51) Int. Cl.: H01L 31/0224

(54) **Halbleiterbauelement und Verfahren zur Herstellung eines Metall-Halbleiter-Kontakts**
Semi-conductor device and method of producing a metal semi-conductor contact
Composant semi-conducteur et procédé de fabrication d'un contact semi-conducteur métallique

(30) Priorität: 13.06.2007 DE 102007027263
(43) Veröffentlichungstag der Anmeldung: 13.03.2013
(62) Teilanmeldung aus: 08158162.1
(73) Patentinhaber: SCHOTT Solar AG, 55122 Mainz (DE)
(72) Erfinder: Wildpanner, Bernd, 01187 Dresden (DE); Von Campe, Dr., Hilmar, 61352 Bad Homburg (DE); Buss, Werner, 63456 Hanau (DE)
(74) Vertreter: Stoffregen, Hans-Herbert

(56) Entgegenhaltungen:
- EP-A- 0 729 189
- EP-A2- 0 538 840
- WO-A1-83/02200
- DE-A1- 2 945 450
- GB-A- 1 018 848
- US-A- 4 336 648

## Beschreibung

Die Erfindung bezieht sich auf ein Halbleiterbauelement umfassend eine aus Halbleitermaterial bestehende erste Schicht wie Substrat, eine auf dieser verlaufende poröse zweite Schicht, zumindest eine erste und eine zweite zwischen der ersten und zweiten Schicht verlaufende aus den Materialien der ersten und zweiten Schicht ausgebildete Zwischenschicht sowie einen eine elektrisch leitende Verbindung mit der ersten Schicht bildenden und von der zweiten Schicht ausgehenden oder diese durchsetzenden elektrisch leitenden Kontakt, wobei Rückseite des Halbleiterbauelements insgesamt oder zumindest teilweise im Bereich der Kontaktstelle von der zumindest zweiten Schicht abgedeckt ist und der elektrisch leitende Kontakt ein lötbares oder metallisch benetzbares Material umfasst, das in der zweiten Schicht einlegiert ist oder mit dem Material der zweiten Schicht ein Gemenge bildet.

Ferner bezieht sich die Erfindung auf ein Verfahren zur Herstellung eines Metall-Halbleiter-Kontakts eines Halbleiterbauelementes, wie Solarzelle, umfassend eine erste Schicht wie Substrat aus Halbleitermaterial sowie eine auf dieser aufgebrachte poröse zweite Schicht aus einem aus Metall bestehenden oder dieses enthaltenden Basis-Kontaktmaterial.

In der Halbleiterfertigung, insbesondere der Solarzellenproduktion, werden aus Produktionskostengründen gesinterte Metallkontakte auf der Vorder- oder Rückseite der Zelle eingesetzt.

Üblicherweise befindet sich auf der Rückseite einer Silizium-Solarzelle eine großflächige Aluminiumschicht, die durch Wärmebehandlung während der Herstellung der Solarzelle einem Sinterprozess ausgesetzt wird, wodurch gleichzeitig eine Passivierung der Solarzellenrückseite durch ein so genanntes Back-Surface-Field (BSF) geschaffen wird.

Beim Sintern wird die Aluminiumschicht, die sich in direktem Kontakt mit dem als erste Schicht zu bezeichnenden Siliziumsubstrat befindet, an der Grenzfläche zwischen der Aluminiumschicht und dem Siliziumsubstrat aufgeschmolzen und legiert mit der angrenzenden ersten Schicht. Beim Abkühlen erstarrt eine hoch mit Al dotierte Siliziumschicht epitaktisch auf der dem Si zugewandten Rückseite des Wafers, also des Substrats. Simultan dazu erstarrt eine mit Silizium angereichterte Al-Schicht auf der der Al-Schicht zugewandten Seite, und am Schluss des Abkühlvorgangs erstarrt ein Al-Si-Eutektikum zwischen der hoch mit Aluminium dotierten Schicht und der mit Silizium angereicherten Schicht. Für die Passivierung der Solarzellenrückseite ist die hoch mit Aluminium dotierte epitaktisch aufgewachsene Siliziumschicht verantwortlich. Durch die hohe Al-Dotierung wird im Halbleitermaterial der Schicht ein Überschuss an negativ geladenen, ortsfesten Al-Akzeptoren gebildet, von denen ein die Minoritätsträger zurücktreibendes elektrisches Feld erzeugt wird, das so genannte Back-Surface-Field.

Wenn sich die Aluminiumschicht über die gesamte Rückseite der Solarzelle bzw. des Substrats erstreckt, gibt es jedoch ein löttechnisches Problem, da es nicht ohne Weiteres möglich ist, z. B. verzinnte oder nicht verzinnte Metallverbinder, insbesondere Kupferverbinder auf der Aluminiumrückseite direkt anzulöten. Um ungeachtet dessen die erforderliche elektrische Kontaktierung durchzuführen, werden üblicherweise Silberkontaktleiterbahnen oder Lötpunkte direkt auf die Substratoberfläche durch Siebdruck, Tampondruck oder andere geeignete Druckverfahren aufgebracht und an diese die verzinnten Kupferbänder angelötet. Folglich ist im Bereich der Lötkontakte eine Aussparung der Aluminiumschicht vorgesehen mit der Folge, dass sich in diesem Bereich kein Back-Surface-Field ausbilden kann, so dass die Solarzellenrückseitenfläche nicht vollständig elektrisch passiviert ist und hierdurch lokal geringere Fotoströme auftreten. Dies hat negative Folgen für die Höhe des Wirkungsgrades.

Da Silber als Rohstoff ein teures Material ist, sollte auch zur Reduzierung der Herstellungskosten darauf verzichtet werden. Daher ist es wünschenswert, den Ag-Kontakt ganz zu vermeiden.

Ein unmittelbares Löten der Kontaktbänder auf der Aluminiumschicht ist aus mehreren Gründen schwer möglich. Ein Grund liegt in der oxidierten Oberfläche der Al-Partikel. Ein weiterer Grund ist, dass die Aluminiumoberseite aufgrund des Sinterprozesses nicht im hinreichenden Umfang zusammenhängend ausgebildet ist. So entsteht während des Sinterprozesses über der mit Si dotierten Legierungsschicht eine Al-Schicht in Form von aus einzelnen kugelförmigen zusammengesinterten Al-Partikeln (Sinterschicht), bei der kein geschlossener, sondern ein relativ locker gesinterter Verbund aus Aluminium vorliegt, der in Abhängigkeit von der Zusammensetzung der Aluminiumpaste bzw. der Prozessparameter beim Sintern mehr oder weniger porös ist. Die Poren können mit Glasbestandteilen ausgefüllt sein.

Sollte es ungeachtet dessen gelingen, auf dieser Sinter-Aluminium-Schicht zu löten, so würde jedoch aufgrund der Porosität und hierdurch bedingten Instabilität der Schicht nur ein sehr geringer Halt gegeben sein. Dieser geringere Halt äußert sich in geringen Abzugskräften von ca. 2-8 N, wobei die Sinterschicht in sich auseinandergerissen wird, so dass man auf beiden Seiten der Abrissstelle die Kugelstruktur der Partikel erkennt. Hierdurch besteht das Risiko, dass die Sinterschicht bei einem Versuch, das Kontaktband abzuziehen, zerstört wird. Dasselbe passiert, wenn die Lötverbindung auf der Aluminiumschicht den in einem Modul unter Betriebsbedingungen wirkenden Zugkräften ausgesetzt ist. Es kann zu kleinen Rissen kommen, die zu einer geringeren Haltbarkeit der Lötstelle führen und auch höhere Übergangswiderstände zur Folge haben können.

Die US-A-4,492,812 bezieht sich auf die Ausbildung von elektrischen Kontakten auf einer Solarzelle. Dabei besteht die Möglichkeit, entweder eine Mischung aus Aluminium und einem lötbaren Metall oder schichtweise Aluminium und ein lötbares Material auf der Rückseite der Solarzelle aufzutragen.

Gegenstand der WO-A-2006/132766 sind bleifreie Solarzellenkontakte. Hierzu wird zunächst eine Silberpaste auf ein Silizium-Wafer aufgetragen und getrocknet. Anschließend wird eine Aluminiumkontaktpaste aufgedruckt und getrocknet.

Auf die Rückseite eines Wafers wird nach der EP-A-0 729 189 eine Silber-Aluminim-Paste oder eine Aluminiumpaste mit kleinen Öffnungen aufgetragen, in die sodann eine Silberpaste eingebracht wird, um elektrische Kontakte anzubringen.

Auf die Herstellung eines photoelektrischen Elements bezieht sich die JP-A-05326990, wobei Silberpaste auf die Rückseite eines Siliziumsubstrats aufgetragen und sodann getrocknet wird. Anschließend wird eine Aluminiumpaste aufgetragen, die teilweise die Silberpaste überdeckt.

Kontakte für Halbleiterbauelemente sind der US-A-4,293,451 zu entnehmen. Dabei werden elementares Metall oder Legierungen oder Kombinationen dieser als Fritte in einem gewünschten Muster für ein Substrat aufgetragen und anschließend gefeuert.

Nach der US-A-4,392,010 wird eine Mischung aus Aluminium und einem lötbaren Material auf eine Siliziumfläche einer Solarzelle aufgetragen, wobei eine Temperatur eingestellt wird, die es ermöglicht, dass sich die Legierung zu dem Silizium und der Mischung ausbildet, um Rückseitenkontakte mit einer Solarzelle mittels Ultraschweißens zu verbinden.

Ein gattungsbildendes Halbleiterbauelement in Form einer Solarzelle ist der WO-A-83/02200 zu entnehmen. Die Solarzelle weist eine aus Aluminium bestehende Rückseitenschicht auf, auf die eine Paste aus Silber oder Silber-Palladium aufgebracht wird. Anschließend erfolgt eine Temperaturbehandlung.

Eine Solarzelle nach der EP-A-0 538 840 weist Zinn enthaltende metallische Reflexionsschichten auf.

Der US-A-4 336 648 ist ein Verfahren zum Kontaktieren einer Solarzelle zu entnehmen. Verbinder werden mittels Ultraschall mit der Vorder- oder Rückseite kontaktiert.

Kontaktschichten können nach der DE-A-29 45 450 durch Flammspritzen oder Plasma-Spritzen auf eine Solarzelle aufgebracht werden.

Nach der GB-A-1 018 848 werden mittels Ultraschall elektrische Leiter mit einem Halbleiterbauelement verschweißt.

Der vorliegenden Erfindung liegt die Aufgabe zugrunde, ein Halbleiterbauelement bzw. ein Verfahren zur Herstellung eines Metall-Halbleiter-Kontakts der eingangs genannten Art so weiterzubilden, dass ein mechanisch haltbarer, elektrisch einwandfrei lötbarer Kontakt im Bereich des Materials der zweiten Schicht, die insbesondere aus Aluminium besteht oder dieses enthält, erzeugt wird, ohne dass das für die Passivierung wesentliche Back-Surface-Field unterbrochen oder geschädigt wird.

Erfindungsgemäß wird die Aufgabe durch ein Halbleiterbauelement zuvor beschriebener Art dadurch gelöst, dass das lötbare oder metallisch benetzbare Material als der elektrisch leitende Kontakt von der zweiten Schicht ausgehend in zumindest einer der beiden Zwischenschichten einlegiert ist oder diese durchdringt.

Metallisch benetzbares Material ist ein Kontaktmaterial, das von der jeweils verwendeten Lotschmelze benetzt wird, mit dem der Verbinder auf- bzw. angelötet wird.

Erfindungsgemäß ergibt sich ein Halbleiterbauelement, dessen Rückseite insgesamt oder zumindest teilweise im Bereich der Lötstelle von der aus Basis-Kontaktmaterial, insbesondere aus Aluminium bestehenden oder zumindest das Basis-Kontaktmaterial wie Aluminium enthaltenden zweiten Schicht abgedeckt ist, die mit dem Halbleitermaterial legiert wird, wodurch sich eine ganzflächige durch ein Back-Surface-Field passivierte Rückseite des Halbleiterbauelementes ergibt. Die das Back-Surface-Field bildende Schicht ist die zweite Zwischenschicht.

Sodann kann auf die zweite Schicht eine ein Lotmaterial enthaltende Schicht wie Sn-Schicht aufgebracht werden, um mittels geeigneter Verfahren derart einlegiert zu werden, dass sich ein bis zu der ersten Schicht durchgehender elektrischer Kontakt ergibt. Über diesen Kontakt besteht die Möglichkeit, auf der Rückseite einen Verbinder wie Kupferverbinder aufzulöten.

Die erste Zwischenschicht ist die mit dem Halbleitermaterial dotierte Schicht aus dem Basis-Kontaktwerkstoff wie Al und/oder zusätzlich dem Lotwerkstoff. Dieser kann aus Sn, SnAg, PbSn, CdSn, SnZn, SnMg, SnBa und/oder SnCa bestehen bzw. eines oder mehrere dieser Materialien umfassen. Dabei kann die erste Zwischenschicht auch ein aus den Materialien der ersten und zweiten Schicht bestehendes Eutektikum umfassen.

Das metallisch benetzbare lötbare Material kann ggf. in einem Umfang in das Halbleiterbauelement einlegiert sein, dass das metallisch benetzbare Material bis in die das Back-Surface-Field bildende mit Basis-Kontaktmaterial dotierte zweite Zwischenschicht als Randschicht der ersten Schicht einlegiert ist. Da die entsprechende zweite Zwischenschicht aus der ersten Schicht ausgebildet ist, erfolgt demzufolge ein Einlegieren bis an die Grenze des Halbleitermaterials, ohne dass jedoch die Funktion des Back-Surface-Fields beeinträchtigt werden sollte. Das metallisch benetzbare lötbare Material kann also bis an das Halbleitermaterial heranreichen, d. h., es kann sogar in die mit dem Basis-Kontaktmaterial dotierte Randschicht einlegieren.

Die zweite Schicht ist zumindest ein Material oder ein Materialgemisch aus der Gruppe Al, In, Ga, B.

Das metallisch benetzbare Material des elektrischen leitenden Kontaktes ist zumindest ein Material aus der Gruppe Sn, Pb, Zn, Mg, Ca, Ba, In, Ga, Cd, Ag, Au, Ni, Fe oder ein sonstiges geeignetes Lotmaterial bzw. eine Mischung von Materialien der entsprechenden Gruppe.

Die zweite Schicht kann auch aus einem Material bestehen, das aus einer Mischung aus dem Basis-Kontaktmaterial wie Al und dem lötbaren Material hergestellt ist.

Der Anteil des zugemischten Materials in der zweiten Schicht kann 0,01 Gew.-% bis 99,9 Gew.-% betragen. Vorzugsweise sind jedoch Bereiche zwischen 10 Gew.-% und 30 Gew.-% bzw. 50 Gew.-% und 70 Gew.-% vorgesehen.

Es ergibt sich erfindungsgemäß ein durchgehender von der ersten Schicht ausgehender und durch die zweite Schicht hindurchgehender elektrischer Kontakt, an dem ein Verbinder wie Kupferverbinder auf der zweiten Schicht angelötet werden kann. Dieser elektrische Kontakt, der bevorzugterweise Sn-Lot ist oder zumindest ein Sn enthaltendes Lot umfasst, füllt die Poren der zweiten Schicht wie Aluminiumsinterschicht und bildet eine zusammenhängende Metallschicht aus. Durch diese Maßnahme wird die beim Sinterprozess hervorgehobene Porosität der Sinterschicht, die für schlechte mechanische Stabilität und schlechte elektrische Kontakteigenschaften verantwortlich ist, zumindest lokal, und zwar dort, wo sich das Lot befindet, aufgehoben.

Alternativ kann die zweite Schicht wie Aluminiumschicht dadurch lötbar gemacht werden, dass der aus dem Basismaterial der zweiten Schicht bestehenden Paste wie Aluminiumpaste in geeigneten Mengen zum Beispiel ein Sn-Pulver oder ein Sn-Al-Legierungspulver zugemischt wird, wodurch erreicht wird, dass sich ein von der aus Halbleitermaterial bestehenden ersten Schicht wie Substrat ausgehender und durch die zweite Schicht wie Aluminiumrückkontaktschicht hindurchgehender elektrischer Kontakt erzeugt wird, an dem ein Kupferverbinder angelötet werden kann.

Es wird ein metallischer elektrischer Kontakt erzeugt, der zumindest bis zur dotierten aus Halbleitermaterial bestehenden Schicht reicht und mit dieser eine mechanisch haftfeste Verbindung eingeht, ohne dass die elektrischen Eigenschaften des Back-Surface-Field beeinträchtigt werden.

Ein Verfahren zur Herstellung eines Metall-Halbleiter-Kontaktes der eingangs genannten Art zeichnet sich dadurch aus, dass nach Ausbilden der zweiten Schicht auf diese ein lötbares oder metallisch benetzbares Material aufgebracht oder zur Ausbildung der zweiten Schicht auf die erste Schicht eine Mischung aus dem Basis-Kontaktmaterial und einem lötbaren Material aufgebracht wird und dass durch mechanische und/oder Wärmebehandlung und/oder durch thermisches Spritzen des lötbaren oder metallisch benetzbaren Materials lötbares oder metallisch benetzbares Material in die zweite Schicht oder in die zweite Schicht oder in die zweite Schicht und in zumindest eine zwischen der ersten und der zweiten Schicht während der Herstellung des Halbleiterbauelementes sich ausbildenden Zwischenschicht einlegiert wird.

Ein mögliches Herstellungsverfahren zeichnet sich dadurch aus, dass das lötbare bzw. metallisch benetzbare Material durch mechanische oder akustomechanische Bearbeitung wie Einreiben oder Einhämmern oder Schall- oder Ultraschallbeaufschlagung des Halbleiterelements unter gleichzeitiger Wärmebehandlung während und/oder nach Ausbildung der zweiten Schicht in die zweite Schicht bzw. bis in die zumindest eine Zwischenschicht und/oder die erste Schicht einlegiert wird. Die Ultraschallbeaufschlagung kann dabei bei einer Frequenz f mit 10 kHz ≤ f ≤ 100 kHz, insbesondere 20 kHz ≤ f ≤ 80 kHz durchgeführt werden. Insbesondere ist dabei vorgesehen, dass das herzustellende Halbleiterbauelement einer Temperatur T mit 0 °C ≤ T ≤ 800 °C, insbesondere 180 °C ≤ T ≤ 350 °C ausgesetzt wird.

Eine weitere Möglichkeit sieht vor, dass das lötbare bzw. metallisch benetzbare Material ausschließlich oder im Wesentlichen ausschließlich durch Wärmebehandlung des herzustellenden Halbleiterbauelementes während oder nach Ausbildung der zweiten Schicht in die zweite Schicht und gegebenenfalls zumindest die erste Zwischenschicht einlegiert wird. Die Wärmebehandlung sollte dabei in einem Temperaturbereich zwischen 150 °C und 1.600 °C (lokal, kurzzeitig), vorzugsweise im Bereich zwischen 230 °C und 450 °C durchgeführt werden.

Bei sehr hohen Temperaturen ist der Wärmeeintrag durch einen Laserstrahl oder eine intensive Lichtquelle (ZMR) vorgesehen. Die Lichtquelle wird durch einen elliptischen Spiegel auf die zu lötenden Bereiche fokussiert und danach über die zu lötenden Bereiche geführt. Alternativ können Lichtpulse auf die zu lötenden Bereiche gegeben werden. Schließlich kann auch ein Laserstrahl über die zu lötenden Bereiche gerastert werden. Eine weitere Möglichkeit zur Erwärmung der zu lötenden Bereiche ist die Einkopplung eines mittel- oder hochfrequenten elektromagnetischen Feldes (Induktivlöten). Hierzu sind Frequenzen im Bereich von 10 kHz bis 10 MHz vorgesehen, vorzugsweise 100 bis 800 kHz.

Wird das lötbare bzw. metallisch benetzbare Material durch thermisches Spritzen aufgebracht, wodurch gleichzeitig ein Durchlegieren vorzugsweise bis zumindest in die erste Zwischenschicht erfolgt, so sollte das lötbare Material mit einer Geschwindigkeit V mit 10 m/s ≤ V < 1000 m/s, vorzugsweise V ≈ 300 m/s aufgebracht werden. Während des Spritzens sollte das herzustellende Halbleiterbauelement des Weiteren einer Temperatur ausgesetzt sein, die im Bereich zwischen 100 °C und 600 °C liegt.

Während des thermischen Spritzens kann das Halbleiterbauelement auch mit Ultraschall einer Frequenz mit insbesondere 10 kHz ≤ f ≤ 100 kHz, vorzugsweise mit 20 kHz ≤ f ≤ 80 kHz beaufschlagt werden.

Alternativ kann auf die erste Schicht eine Mischung aus dem Kontakt-Basismaterial der zweiten Schicht wie Aluminiumpaste und dem metallisch benetzbaren oder lötbaren Material oder mit einer das lötbare Material enthaltenden Legierung aufgetragen werden, um sodann die zweite Schicht auszubilden. Als die Mischung wird insbesondere eine solche verwendet, die x-Gew.% an dem metallisch benetzbaren bzw. lötbaren Material bzw. der das lötbare Material enthaltenden Legierung enthält, wobei 0 Gew.-% < x ≤ 50 Gew.-% oder 50 Gew.-% ≤ x < 100 Gew.-% ist.

Das metallisch benetzbare bzw. lötbare Material kann jedoch auch durch punktuelle Temperaturbeaufschlagung der zweiten Schicht insbesondere durch Löten bis vorzugsweise zumindest in die erste Zwischenschicht einlegiert werden.

Als Kontakt-Basismaterial für die zweite Schicht wird ein solches verwendet, das zumindest ein Material aus der Gruppe Al, In, Ga, B oder eine Mischung aus Materialien der Gruppe ist oder enthält.

Als metallisch benetzbares oder lötbares Material - wie auch z. B. Metall und auch Keramikmaterial - wird insbesondere ein solches verwendet, das zumindest ein Material aus der Gruppe Zinn, Zinnlegierung, Indium, Blei, Kadmium, Gallium, Silber, Gold, Nickel, Eisen, Titan, Hafnium, Zink, Magnesium, Calcium, Barium oder eine Mischung aus Materialien der Gruppe ist oder enthält.

Des Weiteren kann auf dem ganzflächigen Aluminiumkontakt entweder ganzflächig oder zumindest in Teilbereichen ein weiteres metallisch benetzbares Material aufgebracht werden. Als Beispiel für eine ganzflächig aufgebrachte lötbare Schichtstruktur ist eine gesputterte ca. 80 nm dicke Ni:V-Schicht anzusehen.

Als Beispiel für als Schicht in Teilbereichen aufgebrachte Materialien sind Al und Cu oder Ag und Cu zu nennen. Mögliche Metalle sind Ag, Cu, Al, Ni, Zn.

Weitere Einzelheiten, Vorteile und Merkmale der Erfindung ergeben sich nicht nur aus den Ansprüchen, den diesen zu entnehmenden Merkmalen -für sich und/oder in Kombination-, sondern auch aus der nachfolgenden Beschreibung von der Zeichnung zu entnehmenden bevorzugten Ausführungsbeispiel.

Es zeigen:

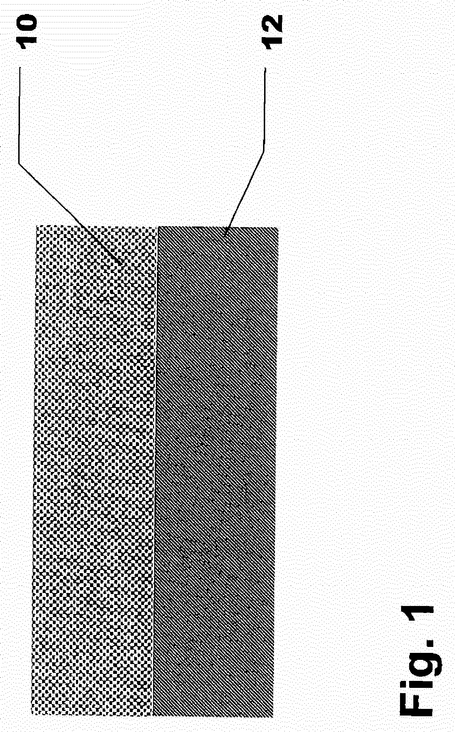

- Fig. 1: eine Prinzipdarstellung eines Abschnitts eines Halbleiterschichtsystems bestehend aus einer ersten Halbleiterschicht und einer zweiten Schicht aus Basis-Kontaktmaterial,

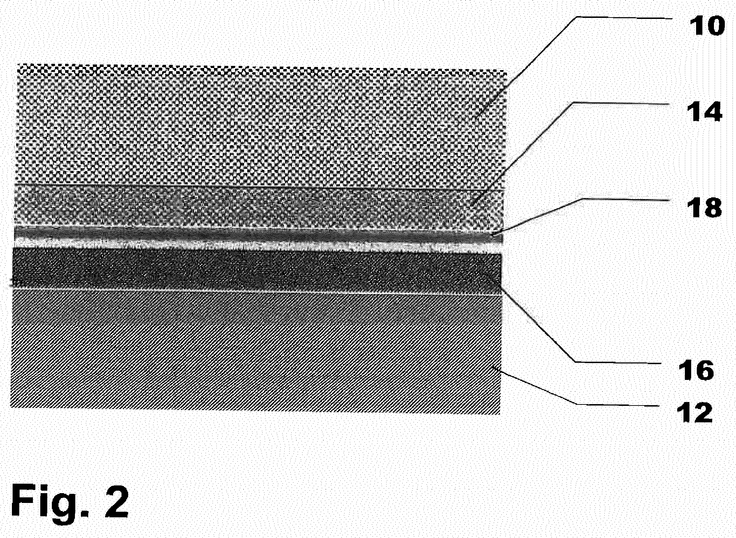

- Fig. 2: einen prinzipiellen Aufbau des Halbleiterbauelements gemäß Fig. 1 mit ausgebildetem Halbleiter-Metall-Kontakt,
- Fig. 3: das Halbleiterbauelement nach Fig. 2 mit aufgebrachtem lötbaren Material,
- Fig. 4: das Halbleiterbauelement gemäß Fig. 2 mit unterschiedlich weit reichendem Halbleiter-Metall-Kontakt und
- Fig. 5: das Halbleiterbauelement gemäß Fig. 2 mit bis zu einer ersten Zwischenschicht reichendem Halbleiter-Metall-Kontakt sowie einem nur in der zweiten Schicht einlegierten Halbleiter-Metall-Kontakt.

Den Figuren ist rein prinzipiell ein Ausschnitt eines Halbleiterbauelementes zu entnehmen, das nachstehend aus Gründen der Vereinfachung als Solarzelle bezeichnet wird. Dargestellt sind dabei ein aus Silizium bestehendes Substrat 10, also Halbleitermaterialschicht - nachstehend auch Halbleiterschicht genannt -, auf dessen bzw. deren Vorderseite in gewohnter Weise halbleitende Schichten zur Ausbildung eines pn-Überganges sowie Frontkontakte und gegebenenfalls Passivierungsschichten aufgetragen sein können. Insoweit wird jedoch auf hinlänglich bekannte Konstruktionen bzw. Aufbauten von Halbleiterbauelementen wie Solarzellen verwiesen, ohne dass es näherer Erläuterungen bedarf.

Auf die als erste Schicht bezeichnete Halbleiterschicht 10 wird z. B. mittels Siebdruck, Tampondruck, thermisches Spritzen, eine Schicht aus einem Metall bzw. Halbmetallmaterial - nachstehend beispielhaft für alle in Frage kommenden Materialien als Aluminium bezeichnet - aufgebracht, die einem Sinterprozess bei der Herstellung der Solarzelle ausgesetzt wird, wodurch sich eine äußere Aluminiumsinterschicht 12 als zweite Schicht ergibt. Zwischen der Aluminiumsinterschicht 12 und dem Siliziumsubstrat 10 werden bei der Herstellung eine das Back-Surface-Field bildende mit Aluminium dotierte Siliziumschicht 14 und eine mit Silizium dotierte Aluminiumschicht 16 mit Al-Si-Eutektikum 18 ausgebildet. Insoweit wird jedoch ebenfalls auf den hinlänglich bekannten Stand der Technik verwiesen. Die mit Silizium dotierte Aluminiumschicht 16 wird als erste Zwischenschicht und die mit Aluminium dotierte Siliziumschicht wird als zweite Zwischenschicht 14 bezeichnet.

Die äußere oder zweite aus Aluminium bestehende Schicht 12 ist erfindungsgemäß aufgrund des Sinterprozesses porös und weist demzufolge eine Vielzahl von Hohlräumen auf

Zu den Schichten 10, 12, und Zwischenschichten 14, 16 einschließlich dem Eutektikum 18 ist anzumerken, dass diese zeichnerisch rein prinzipiell dargestellt sind, ohne dass diese die tatsächlichen Dimensionierungen widerspiegeln.

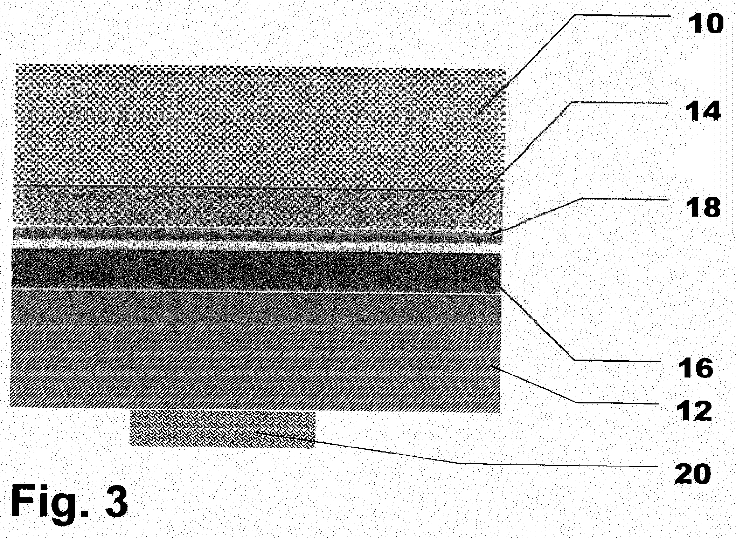

Um auf die als zweite Schicht zu bezeichnende Aluminiumsinterschicht 12 einen Verbinder wie Kupferverbinder zum Kontaktieren auflöten zu können, wird entsprechend der zeichnerischen Darstellung der Fig. 3 auf die zweite Schicht 12 ganzflächig oder in Teilbereichen ein metallisch benetzbares bzw. lötbares Material enthaltende oder aus diesem bestehende Schicht 20 aufgebracht. Dies ist rein beispielhaft zu verstehen, da - wie nachstehend erläutert wird - andere Möglichkeiten bestehen, um lötbares bzw. metallisch benetzbares Material derart in Schichten einzubringen, dass sich ein lötbarer Kontakt ergibt.

Unter dem Begriff lötbares Material wird auch metallisch benetzbares Material subsumiert, also Kontaktmaterial, das von der jeweils verwendeten Lötschmelze benetzt wird, mit dem der Verbinder auf- bzw. angelötet wird.

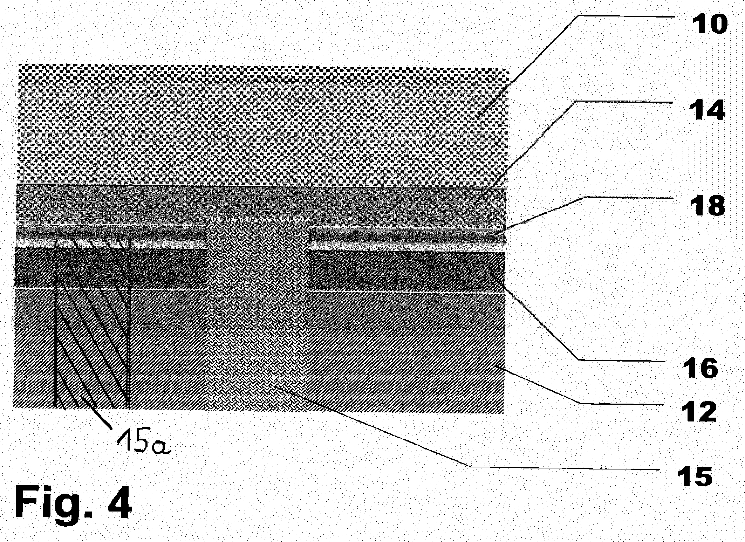

Zeichnerisch ist erwähntermaßen vorgesehen, dass auf die zweite Schicht 12, also Sinterschicht die vorzugsweise Sn enthaltende oder aus Sn bestehende oder eine Sn-Legierung enthaltende Schicht 20 aufgebracht wird, um sodann durch z. B. punktuelle Wärmebeaufschlagung wie zum Beispiel durch Löten das lötbare Material aus der Schicht 20 bis zumindest in den Randbereich der das Back-Surface-Field bildenden und mit Aluminium dotierten Si-Randschicht als die zweite Zwischenschicht 14 einzulegieren. Dies wird anhand der Schraffur in Fig. 4 verdeutlicht. Auf den entsprechenden mit den Bezugszeichen 15 gekennzeichneten Bereich kann sodann ein Verbinder wie Kupferverbinder aufgelötet werden, so dass die erforderliche elektrische Verschaltung des Halbleiterbauelementes ermöglich wird, ungeachtet der Tatsache, dass die Rückseite mit der zweiten Schicht 12 wie der Aluminiumsinterschicht dem Grunde nach nicht lötbar ist. Der Bereich 15 ist der elektrisch leitende Kontakt.

Zur Ausbildung des Halbleiter-Metall-Kontaktes bestehen verschiedene Möglichkeiten, die nachstehend prinzipiell erläutert werden.

Durch Einbringen von akustomechanischen Schwingungen und Wärme in ein bestehendes System aus der Halbleiterschicht wie Si-Schicht als die erste Schicht 10, der aus dem Basis-Kontaktmaterial wie zum Beispiel Aluminium, Indium, Gallium, Bor oder einer hieraus gebildeten Mischung bestehenden zweiten Schicht 12 und der zwischen diesen verlaufenden Zwischenschichten 14, 16, 18 wird das auf der zweiten Schicht 12 aufgebrachte lötbare Material 20 bis in den Randbereich der mit Aluminium dotierten Siliziumschicht 14, die das Back-Surface-Field bildet, einlegiert. Alternativ kann sich das lötbare Material sich bereits in der zweiten Schicht 12 befinden. Die erforderliche Schwingung wird durch Ultraschallbeaufschlagung erzeugt, wobei Frequenzen zwischen 10 kHz und 100 kHz, vorzugsweise im Bereich zwischen 20 kHz und 80 kHz appliziert werden. Während des Einlegierens des lötbaren Materials sollte das Halbleiterbauelement auf eine gewünschte Temperatur erwärmt werden, die zwischen 0 °C und 600 °C, vorzugsweise zwischen Raumtemperatur und 300 °C liegen kann.

Alternativ kann allein eine Wärmebehandlung zum Einlegieren des lötbaren Materials erfolgen, wobei Temperaturen zur Anwendung gelangen, die oberhalb der Schmelztemperatur des lötbaren Materials liegen. Bevorzugte Temperaturwerte liegen zwischen 230 °C und 900 °C, insbesondere 350 °C und 400 °C, und zwar in Abhängigkeit von dem lötbaren Material, bei dem es sich insbesondere um Zinn, Indium, Blei, Gallium, Cadmium, Silber, Gold, Nickel, Eisen, Titan, Hafnium, Zink, Magnesium, Calcium, Barium oder eine hieraus gebildete Mischung handeln kann. Das lötbare und einzulegierende Material kann bevorzugterweise nach Ausbilden der Sinterschicht 12 aufgetragen werden.

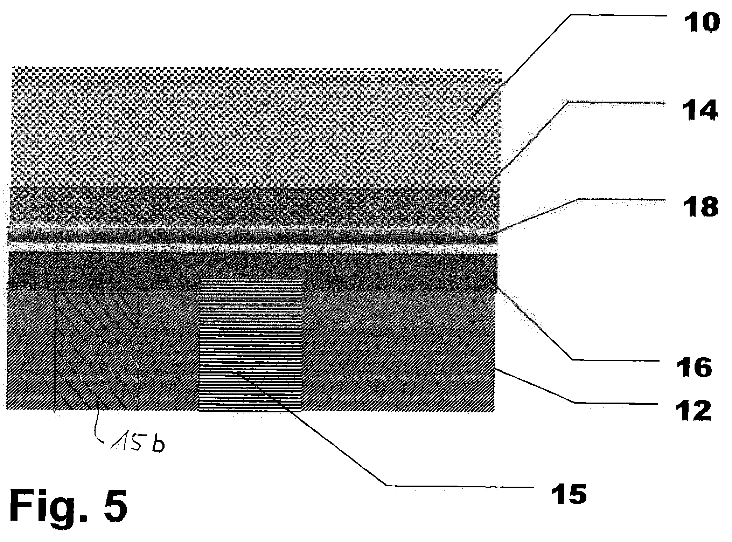

Es besteht jedoch auch die Möglichkeit, zur Herstellung der Sinterschicht 12 ein Ausgangsmaterial bzw. eine Paste zu verwenden, die bereits das lötbare Material enthält. In diesem Fall ergibt sich durch die Wärmebehandlung wie z. B. im Sinterprozess bei 700 °C bis 1000 °C in der Schicht 12 ein Gemenge aus dem Basis-Kontaktmaterial der zweiten Schicht 12 und dem lötbaren Material, das aufgrund der Wärmebehandlung in die zumindest erste Zwischenschicht 16, also im Ausführungsbeispiel in die mit Silizium dotierte Aluminiumschicht einlegiert wird (Bereich 15 in Fig. 5). Es kann ein weiteres Einlegieren bis in den Randbereich der das Back-Surface-Field bildenden Schicht 14 erfolgen (Bereich 15 in Fig. 4).

Eine weitere Möglichkeit, um das lötbare Material in die zumindest erste Zwischenschicht 16 bzw. bis in die zweite Zwischenschicht 14 einzubringen, besteht darin, dass das lötbare Material durch thermisches Spritzen auf die gesinterte Aluminiumschicht 12 aufgetragen wird. Zusätzlich können eine Ultraschallbeaufschlagung und/oder eine Wärmebehandlung erfolgen. Wird das Halbleiterbauelement zum Einlegieren des lötbaren Materials in Schwingung versetzt, so sollte Ultraschall im Frequenzbereich zwischen 10 kHz und 100 kHz, vorzugsweise im Bereich zwischen 20 kHz und 80 kHz appliziert werden. Das lötbare Material selbst sollte mit einer Geschwindigkeit zwischen 10 m/s und 1000 m/s, vorzugsweise im Bereich von 300 m/s auftreffen.

Wie bereits zuvor erläutert worden ist, kann der Halbleiter-Metall-Kontakt auch durch herkömmliche Löttechnik hergestellt werden. Hierzu wird bei der Herstellung des Halbleiterbauelementes eine Paste aus Basis-Kontaktmaterial für den Rückkontakt mit Anteilen von lötbarem Material wie Sn oder Sn-Al-Legierungsbestandteilen aufgetragen. Bereits bei der Herstellung des Halbleiterbauelementes bzw. der Solarzelle, also bei der Formation des Rückkontaktes an der Aluminium-Silizium-Grenzfläche, also im Übergangsbereich zwischen den Schichten 14 und 16 wird eine zusammenhängende Al-Sn-Schicht ausgebildet, die sich als Al-Sn-Schicht bis zur rückseitigen Außenfläche erstreckt.

Wird eine Aluminiumpaste mit Sn-Bestandteilen benutzt, so können deren Sn-Anteile im Bereich zwischen 0 at.-% < x < 50 at.-% liegen. Wegen der äußerst geringen Löslichkeit von Sn in Silizium, die (im binären Phasendiagramm Si-Sn) bei 700 °C 0,05 at.-% und bei 900 °C bei 0,08 at.-% liegt, besteht während der Legierungsphase bei der Rückkontaktbildung der Al-Anteil fort, so dass die Al-Si-Legierungsschicht und die hoch mit Al-dotierte, für das Back-Surface-Field an der Rückseite verantwortlich epitaktisch gewachsene Si-Schicht 14 in Gegenwart von Sn ungestört wachsen kann. Da Sn isoelektronisch zu Si ist, ergibt sich hieraus keine erhebliche Veränderung der elektrischen Eigenschaften des Rückkontaktes. Somit können herkömmliche Prozessparameter beibehalten werden, so dass infolgedessen Änderungen der Technologie nicht erforderlich sind.

Es besteht aber auch die Möglichkeit, dass die Aluminiumpaste Sn-Bestandteile im Bereich zwischen 50 at.-% und weniger als 100 at.-% enthält. Bei der entsprechenden Zusammensetzung schmilzt die gesamte Rückseitenmetallisierung schon bei niedrigen Temperaturen im Bereich zwischen 230 °C und 580 °C auf, so dass sich eine aluminiumhaltige Al-Si-Grenzschicht bildet. Wegen der geringen Löslichkeit von Sn in Si gelten die zuvor erfolgten Erläuterungen.

Die Unterschiede zwischen den zuvor beschriebenen Herstellungsverfahren der Kontakte durch Verwendung von Pasten mit unterschiedlichen Sn-Bestandteilen liegt darin, dass bei einem Sn-Anteil ≤ 50 % die höhere Kontaktschicht durch Legierungsbildung zwischen Al und Si nur bis zu einem gewissen Grad aufschmilzt, während bei einem höheren Sn-Anteil (50 % bis weniger als 100 %) die Rückkontaktschicht durch Legierungsbildung zwischen Al und Sn komplett flüssig wird.

Hiervon reicht der Sn-Anteil der Schicht zumindest bis zur Al-Si-Sn-Legierungsschicht 16 hindurch, wie dies prinzipiell in der Fig. 5 angedeutet ist.

Ein weiteres Verfahren zur Ausbildung des Halbleiter-Metall-Kontaktes besteht darin, dass beim Auflöten von lötbarem Material auf der Rückseite des Halbleitermaterials ein Durchlegieren erfolgt. In diesem Fall weist die zweite Schicht gleichfalls ein entsprechendes lötbares Material definierter Einstellung auf. Nachfolgend wird dabei davon ausgegangen, dass das Basismaterial der zweiten Schicht 12 Aluminium und das Lötmaterial Sn ist. Wird Sn-Lot von der Rückseite aufgelötet, so ergibt sich eine lokale Anreicherung der Al-Sn-Legierung mit Sn und daraus eine von der Menge an zur Verfügung stehende Sn abhängige unterschiedliche Zusammensetzung der Al-Schicht. Durch die begrenzte Löttemperatur wird die Eindringtiefe der Lötlegierung/Lötzone definiert. Bei einer Löttemperatur von 250 °C gehen 2 at.-% Aluminium in Lösung. Da jedoch der Sn-Gehalt in der Metallrückkontaktschicht 12 entsprechend der Gleichgewichtstemperatur definiert eingestellt worden ist, reicht diese Schicht bis zur Grenzfläche der Legierungsschicht 16. Die Lötung geht in die Metallschicht hinein, wobei sich die Konzentration ändert, da der Al-Gehalt stark zunimmt. Wird der Sn-Anteil sehr hoch, kann die Schmelzzone hindurchlaufen. Der Löteffekt kann dadurch verstärkt werden, dass die Metallkontaktschicht 12 mit Sn angereichert wird. Durch geeignete Zusammensetzung der Al-Sn-Legierung kann die Eindringtiefe bei vorgegebener Temperatur eingestellt werden.

Während der Bildung der Legierungsschicht im Kontakt während der Sinterphase verbinden sich Al und Sn zu einer zusammenhängenden Schicht, die porös ist für die Zusammensetzung bei einem Gewichtsanteil von weniger als 50 % bezogen auf Sn und kompakt bei einer Zusammensetzung, wenn der Sn-Anteil mehr als 50 Gew.-% beträgt. Hierdurch kann eine Lötung an Sn-haltigen Teilchen oder Teilbereichen der Legierungsschicht erfolgen. Wird der Sn-Gehalt erhöht, kann die Löttemperatur gesenkt werden.

In der Fig. 4 ist mit dem Bezugszeichen 15 der von der Außenfläche der zweiten Schicht 12 ausgehende elektrisch leitende Kontakt 15 dargestellt, der sich bis in die zweite Zwischenschicht 14, also in die mit Aluminium dotierte Siliziumschicht erstreckt, die das Back-Surface-Field bildet. In Fig. 5 verläuft der elektrisch leitende Kontakt von der Sinterschicht, also zweiten Schicht 12 bis zur ersten Zwischenschicht 16, die die mit Silizium dotierte Aluminiumschicht ist. Es besteht jedoch auch die Möglichkeit, dass der elektrische Kontakt sich bis zu dem Al-Si-Eutektikum 18 erstreckt, wie der in Fig. 4 eingezeichnete und mit dem Bezugszeichen 15a versehene Bereich verdeutlicht.

Eine weitere Möglichkeit besteht darin, dass der elektrische Kontakt nur in der zweiten Schicht 12 einlegiert ist, wie der in Fig. 5 eingezeichnete und mit dem Bezugszeichen 15b versehene Bereich verdeutlicht.

## Patentansprüche

1. Halbleiterbauelement, umfassend eine aus Halbleitermaterial bestehende erste Schicht (10), wie Substrat, eine auf dieser verlaufende zweite Schicht (12), mindestens zwei zwischen der ersten und zweiten Schicht verlaufende aus den Materialien der ersten und zweiten Schicht ausgebildete Zwischenschichten (14, 16), wobei die der zweiten Schicht (12) zugewandte erste Zwischenschicht (16) ein eutektisches Gemisch (18) aus den Materialien der ersten und der zweiten Schicht enthalten kann, sowie einen eine elektrisch leitende Verbindung mit der ersten Schicht bildenden und von der zweiten Schicht ausgehenden oder diese durchsetzenden elektrisch leitenden Kontakt (15, 15a, 15b), wobei Rückseite des Halbleiterbauelements insgesamt oder zumindest teilweise im Bereich der Kontaktstelle von der zumindest zweiten Schicht (12) abgedeckt ist und
der elektrisch leitende Kontakt (15, 15a, 15b) ein lötbares oder metallisch benetzbares Material umfasst, das in der zweiten Schicht (12) einlegiert ist oder mit dem Material der zweiten Schicht ein Gemenge bildet,
**dadurch gekennzeichnet,**
**dass** das lötbare oder metallisch benetzbare Material als der elektrisch leitende Kontakt (15, 15a, 15b) von der zweiten Schicht (12) ausgehend in zumindest einer der beiden Zwischenschichten (14, 16) einlegiert ist oder diese durchdringt, wobei die zweite Schicht (12) porös ist.

2. Halbleiterbauelement nach Anspruch 1,
**dadurch gekennzeichnet,**
**dass** zwischen der ersten Schicht (10) und der an die zweite Schicht (12) angrenzenden ersten Zwischenschicht (16) die mit dem Material der zweiten Schicht dotierte zweite Zwischenschicht (14) verläuft, bis zu der sich der elektrisch leitende das lötbare oder metallisch benetzbare Material enthaltende Kontakt (15, 15a, 15b) erstreckt.

3. Halbleiterbauelement nach Anspruch 1 oder 2,
**dadurch gekennzeichnet,**
**dass** die zweite Schicht (12) zumindest ein Basis-Kontaktmaterial aus der Gruppe Al, In, Ga, B oder eine Mischung von Materialien der Gruppe ist oder enthält und/oder zumindest bereichsweise aus einem Gemenge aus Al und dem lötbaren oder metallisch benetzbaren Material besteht oder dass die zweite Schicht (12) aus einem Material besteht, das aus einer Mischung aus Al und dem lötbaren oder metallisch benetzbaren Material hergestellt ist.

4. Halbleiterbauelement nach zumindest einem der vorhergehenden Ansprüche,
**dadurch gekennzeichnet,**
**dass** das lötbare oder metallisch benetzbare Material, das vorzugsweise zumindest ein Material aus der Gruppe Sn, Pb, In, Ga, Cd, Fe, Ag, Au, Ti, Hf, Zn, Mg, Ca, Ba, Lotmaterial oder eine Mischung von Materialien der Gruppe ist oder enthält, nach Ausbildung der zweiten Schicht (12) in diese einlegiert ist oder dass in die ein Back-Surface-Field bildende und aus mit dem Basiskontaktmaterial der zweiten Schicht (12) legiertem Halbleitermaterial bestehende zweite Zwischenschicht (14) das lötbare oder metallisch benetzbare Material einlegiert ist.

5. Halbleiterbauelement nach zumindest einem der vorhergehenden Ansprüche,
**dadurch gekennzeichnet,**
**dass** in der aus der ersten Schicht (10) ausgebildeten zweiten Zwischenschicht (14) Basis-Kontaktmaterial der zweiten Schicht (12) sowie lötbares oder metallisch benetzbares Material gelöst sind.

6. Halbleiterbauelement nach zumindest einem der vorhergehenden Ansprüche,
**dadurch gekennzeichnet,**
**dass** die zweite Schicht (12) 0,01 Gew.-% bis 99,9 Gew.-%, insbesondere 10 Gew.-% bis 50 Gew.-% lötbares oder metallisch benetzbares Material wie Zinn bzw. eine Zinnlegierung enthält.

7. Verfahren zur Herstellung eines Metall-Halbleiter-Kontakts (15, 15a, 15b) eines Halbleiterbauelementes, wie Solarzelle, umfassend eine erste Schicht (10), wie Substrat, aus Halbleitermaterial sowie eine auf dieser aufgebrachte poröse zweite Schicht (12) aus einem aus Metall bestehendem oder Metall enthaltendem Basis-Kontaktmaterial, wobei
nach Ausbilden der zweiten Schicht (12) auf der Rückseite des Halbleiterbauelements insgesamt oder teilweise im Bereich von auszubildenden Kontaktstellen auf der zweiten Schicht ein lötbares oder metallisch benetzbares Material (20) aufgebracht oder zur Ausbildung der zweiten Schicht auf die erste Schicht (10) eine Mischung aus dem zweiten Material und einem lötbaren oder metallisch benetzbaren Material aufgebracht wird und wobei durch mechanische Behandlung und/oder Wärmebehandlung und/oder thermisches Spritzen des lötbaren oder metallisch benetzbaren Materials lötbares oder metallisch benetzbares Material in die zweite Schicht und zumindest in eine zwischen der ersten und der zweiten Schicht während der Herstellung des Halbleiterbauelementes sich ausbildende Zwischenschicht (14, 16, 18) einlegiert wird.

8. Verfahren nach Anspruch 7,
**dadurch gekennzeichnet,**
**dass** das lötbare oder metallisch benetzbare Material ausschließlich oder im Wesentlichen ausschließlich durch Wärmebehandlung des herzustellenden Halbleiterbauelementes während und/oder nach Ausbildung der zweiten Schicht (12) in die zweite Schicht oder in die zweite Schicht (12) und in die zumindest eine Zwischenschicht (14, 16, 18) einlegiert wird, wobei vorzugsweise die Wärmebehandlung bei einer Temperatur T mit 150 °C ≤ T ≤ 800 °C, insbesondere 230 °C ≤ T ≤ 600 °C durchgeführt wird.

9. Verfahren nach Anspruch 7,
**dadurch gekennzeichnet,**
**dass** das lötbare oder metallisch benetzbare Material durch akustomechanische Behandlung in die zweite Schicht oder in die zweite Schicht (12) und in die zumindest eine Zwischenschicht (14, 16, 18) einlegiert wird.

10. Verfahren nach einem der vorhergehenden Ansprüche 7 bis 9,
**dadurch gekennzeichnet,**
**dass** das lötbare oder metallisch benetzbare Material des herzustellenden Halbleiterbauelementes während und/oder nach Ausbildung der zweiten Schicht (12) bis in die zweite Schicht oder in die zweite Schicht und die zumindest eine Zwischenschicht (14, 16, 18) einlegiert wird, wobei insbesondere die Ultraschallbeaufschlagung bei einer Frequenz f mit 10 kHz ≤ f ≤ 100 kHz, insbesondere 20 kHz ≤ f ≤ 80 kHz, vorzugsweise 20 kHz oder 40 kHz durchgeführt wird, und dass vorzugsweise während der Ultraschallbeaufschlagung das herzustellende Halbleiterbauelement eine Temperatur T mit 0 °C ≤ T ≤ 1.000 °C, insbesondere 20 °C ≤ T ≤ 600 °C ausgesetzt wird.

11. Verfahren nach einem der vorhergehenden Ansprüche 7 bis 10,
**dadurch gekennzeichnet,**
**dass** das lötbare Material durch thermisches Spritzen auf die zweite Schicht (12) aufgebracht wird, wobei insbesondere das lötbare oder metallisch benetzbare Material mit einer Geschwindigkeit v mit 10 m/s ≤ v ≤ 3000 m/s, vorzugsweise v ≈ 300 m/s aufgetragen wird, wobei vorzugsweise während des thermischen Spritzens das herzustellende Halbleiterbauelement einer Temperatur T mit 0 °C ≤ T ≤ 500 °C, vorzugsweise 20 °C ≤ T ≤ 600 °C ausgesetzt wird und/oder dass während des thermischen Spritzens das herzustellende Halbleiterbauelement mit Ultraschall einer Frequenz f mit insbesondere 10 kHz ≤ f ≤ 100 kHz, vorzugsweise 20 kHz ≤ f ≤ 80 kHz, besonderes bevorzugt 20 kHz oder 40 kHz beaufschlagt wird.

12. Verfahren nach einem der vorhergehenden Ansprüche 7 bis 11,
**dadurch gekennzeichnet,**
**dass** auf die erste Schicht (10) eine Mischung aus dem Basis-Kontaktmaterial der zweiten Schicht (12) wie Al-Paste und dem lötbaren oder metallisch benetzbaren Material oder eine das lötbare oder metallisch benetzbare Material enthaltende Legierung aufgebracht und sodann die zweite Schicht (12) ausgebildet wird, wobei insbesondere als Mischung eine solche verwendet wird, deren Anteil x an lötbarem oder metallisch benetzbaren Material bzw. das lötbare Material enthaltender Legierung beträgt 0 Gew.-% < x ≤ 50 Gew.-% oder 50 Gew.-% ≤x < 100 Gew.-%.

13. Verfahren nach einem der vorhergehenden Ansprüche 7 bis 12,
**dadurch gekennzeichnet,**
**dass** das lötbare oder metallisch benetzbare Material durch punktuelle Temperaturbeaufschlagung der zweiten Schicht (12) insbesondere durch Löten in die zweite Schicht oder in die zweite Schicht bis zumindest der einen Zwischenschicht einlegiert wird.

14. Verfahren nach einem der vorhergehenden Ansprüche 7 bis 13,
**dadurch gekennzeichnet,**
**dass** als Basis-Kontaktmaterial für die zweite Schicht (12) ein solches verwendet wird, das zumindest ein Material aus der Gruppe Al, In, Ga, B oder eine Mischung aus Materialien der Gruppe ist oder enthält und/oder dass als lötbares oder metallisch benetzbares Material ein solches verwendet wird, das zumindest ein Material aus der Gruppe Sn, In, Pb, Ga, Ag, Au, Cd, Fe, Ti, Hf, Zn, Mg, Ca, Ba oder eine Mischung aus Materialien der Gruppe ist oder enthält, wobei insbesondere als lötbares oder metallisch benetzbares Material eine Sn-Legierung oder eine solche enthaltend verwendet wird.

15. Verfahren nach einem der vorhergehenden Ansprüche 7 bis 14,
**dadurch gekennzeichnet,**
**dass** zwischen der ersten Schicht (10) und der zweiten Schicht (12) eine erste Zwischenschicht (16), die eine mit dem Material der ersten Schicht legierte Schicht der zweiten Schicht ist, eine zweite Zwischenschicht (14), die eine mit dem Material der zweiten Schicht legierte Schicht der ersten Schicht ist, sowie zwischen der ersten Zwischenschicht und der zweiten Zwischenschicht verlaufendes Eutektikum (18) ausgebildet werden.

## Claims

1. A semiconductor component comprising a first layer (10) comprising a semiconductor material, as a substrate, a second layer (12) running on said first layer, at least two intermediate layers (14, 16) made of the materials of the first and second layers running between the first and second layer, where the first intermediate layer (16) facing the second layer (12) may contain a eutectic mixture (18) of the materials of the first and second layers as well as an electroconductive contact (15, 15a, 15b) forming an electroconductive connection to the first layer and originating at or running through the second layer, wherein
in the area of the contact point, back side of the semiconductor component is entirely or at least partially covered by the at least second layer (12), and
the electroconductive contact (15, 15a, 15b) comprises a solderable or wettable metallic material, which is alloyed into the second layer (12) or forms a mixture with the material of the second layer,
**characterized in that**
the solderable or wettable metallic material as the electroconductive contact (15, 15a, 15b) originating at the second layer (12), is alloyed into at least one of the intermediate layers (14, 16) or passes through the intermediate layers, wherein the second layer (12) is porous.

2. The semiconductor component according to claim 1,
**characterized in that**
the second intermediate layer (14) doped with the material of the second layer runs between the first layer (10) and the first intermediate layer (16) adjacent to the second layer (12), extending to the electroconductive contact (15, 15a, 15b) containing the solderable or wettable metallic material.

3. The semiconductor component according to claim 1 or 2,
**characterized in that**
the second layer (12) is or contains at least one basic contact material selected from the group consisting of Al, In, Ga, B or mixtures thereof and/or at least in certain areas, comprises a mixture made of Al and the solderable or wettable metallic material or that the second layer (12) comprises a material which is produced with a mixture of Al and the solderable or wettable metallic material.

4. The semiconductor component according to at least one of the preceding claims,
**characterized in that**
the solderable or wettable metallic material preferably is or contains at least one material selected from the group consisting of Sn, Pb, In, Ga, Cd, Fe, Ag, Au, Ti, Hf, Zn, Mg, Ca, Ba, soldering material or mixtures thereof, is alloyed into said second layer (12) after its formation, or that the solderable or wettable metallic material is alloyed into the second intermediate layer (14) forming a back-surface field and comprising the semiconductor material alloyed with the base contact material of the second layer (12).

5. The semiconductor component according to at least one of the preceding claims,
**characterized in that**
the basic contact material of the second layer (12) as well as the solderable or wettable metallic material is dissolved in the second intermediate layer (14) that is configured from the first layer (10).

6. The semiconductor component according to at least one of the preceding claims,
**characterized in that**
the second layer (12) contains from 0.01 % by weight to 99.9 % by weight, in particular from 10% by weight to 50% by weight solderable or wettable metallic material, like tin and/or a tin alloy.

7. A method for producing a metal semiconductor contact (15, 15a, 15b) of a semiconductor component, such as a solar cell, comprising a first layer (10) as a substrate, made of semiconductor material as well as a porous second layer (12) applied onto said first layer (10) made of a contact material consisting of metal or metal containing basic contact material, wherein
after formation of the second layer (12) on the back side of the semiconductor component a solderable or wettable metallic material (20) is applied - entirely or partially in an area of contact points to be formed - onto said second layer or for the formation of the second layer a mixture of the second material and a solderable or wettable metallic material is applied onto the first layer (10), and wherein by means of mechanical and/or thermal treatment and/or thermal spraying a solderable or wettable metallic material is alloyed into the second layer and at least into an intermediate layer (14, 16, 18) that forms between the first and second layers during production of the semiconductor component.

8. The method according to claim 7,
**characterized in that**
the solderable or wettable metallic material is exclusively or essentially exclusively alloyed into the second layer or into the second layer (12) and into the at least one intermediate layer (14, 16, 18) by means of thermal treatment of the semiconductor component to be produced during and/or after formation of the second layer (12), wherein preferably the thermal treatment is performed at a temperature T of 150 °C ≤ T ≤ 800 °C, in particular 230 °C ≤ T ≤ 600 °C.

9. The method according to claim 7,
**characterized in that**
the solderable or wettable metallic material is alloyed into the second layer or into the second layer (12) and the at least one intermediate layer (14, 16, 18) by means of acousto-mechanical treatment.

10. The method according to one of the preceding claims,
**characterized in that**
the solderable or wettable metallic material of the semiconductor component to be produced is alloyed into the second layer or into the second layer (12) and into the at least one intermediate layer (14, 16, 18) during and/or after formation of the second layer (12), wherein in particular the ultrasound waves are applied at a frequency f of 10 kHz ≤ f ≤ 100 kHz, in particular 20 kHz ≤ f ≤ 80 kHz, preferably 20 kHz or 40 kHz and that preferably during ultrasound application, the semiconductor to be produced is exposed to a temperature T of 0 C < T ≤ 1,000 °C, in particular 20 °C ≤ T ≤ 600 °C.

11. The method according to one of the preceding claims 7 to 10,
**characterized in that**
the solderable material is applied onto the second layer (12) by means of thermal spraying, wherein in particular the solderable or wettable metallic material is applied at a velocity v of 10 m/s ≤ v ≤ 3000 m/s, preferably v ≈ 300 m/s, wherein preferably during thermal spraying, the semiconductor to be produced is exposed to a temperature T of 0 °C ≤ T ≤ 500 °C, in particular 20 °C ≤ T ≤ 600 °C, and/or that during thermal spraying the semiconductor component to be produced is treated with ultrasound at a frequency f of particularly 10 kHz ≤ f ≤ 100 kHz, preferably 20 kHz ≤ f ≤ 80 kHz, and highly preferably 20 kHz or 40 kHz.

12. The method according to one of the preceding claims 7 to 11,
**characterized in that**
a mixture made of the basic contact material of the second layer (12), such as an Al paste, and of the soldering or wettable metallic material or an alloy containing the solderable or wettable metallic material is applied onto the first layer (10) and that the second layer (12) is formed afterward, wherein in particular a mixture is used whose portion x of solderable or wettable metallic material and/or of an alloy containing the soldering material is 0 % by weight < x ≤ 50 % by weight or 50 % by weight ≤ x < 100 % by weight.

13. The method according to one of the preceding claims 7 to 12,
**characterized in that**
the solderable or wettable metallic material is alloyed in particular by soldering into the second layer or into the second layer up to the at least one intermediate layer by means of selective temperature application to the second layer (12).

14. The method according to one of the preceding claims 7 to 13,
**characterized in that**
as a basic contact material for the second layer (12) such material is used that at least is or contains a material selected from the group consisting of Al, In, Ga, B or mixtures thereof, and/or that as a solderable or wettable metallic material, such material is used that at least is or contains a material selected from the group consisting of Sn, In, Pb, Ga, Ag, Au, Cd, Fe, Ti, Hf, Zn, Mg, Ca, Ba or mixtures thereof, wherein, in particular, as a solderable or wettable metallic material a Sn alloy or a material containing such an alloy is used.

15. The method according to one of the preceding claims 7 to 14,
**characterized in that**
between the first layer (10) and the second layer (12), a first intermediate layer (16), which is a layer of the second layer that is alloyed with the material of the first layer, a second intermediate layer (14), which is a layer of the first layer that is alloyed with the material of the second layer, as well as a eutectic (18) that runs between the first intermediate layer and the second intermediate layer are formed.

## Revendications

1. Composant à semi-conducteurs, comprenant d'une part une première couche (10), telle qu'un substrat, constituée d'un matériau semi-conducteur, une deuxième couche (12) s'étendant sur la première couche, au moins deux couches intermédiaires (14, 16) s'étendant entre la première et la deuxième couches et formées des matériaux de la première et de la deuxième couches, la première couche intermédiaire (16) tournée vers la deuxième couche (12) pouvant contenir un mélange eutectique (18) des matériaux de la première et de la deuxième couches, ledit composant comprenant d'autre part un contact électroconducteur (15, 15a, 15b) formant une liaison électroconductrice avec la première couche et partant de la deuxième couche ou traversant cette dernière, sachant que la face arrière du composant à semi-conducteurs est recouverte en totalité ou au moins partiellement dans la zone du point de contact par l'au moins deuxième couche (12) et que
le contact électroconducteur (15, 15a, 15b) comprend un matériau brasable ou mouillable par métal qui est incorporé par alliage dans la deuxième couche (12) ou forme un mélange avec le matériau de la deuxième couche,
**caractérisé en ce**
**que** le matériau brasable ou mouillable par métal en tant que contact électroconducteur (15, 15a, 15b) est incorporé par alliage à partir de la deuxième couche (12) dans au moins l'une des deux couches intermédiaires (14, 16) ou traverse cette dernière, sachant que la deuxième couche (12) est poreuse.

2. Composant à semi-conducteurs selon la revendication 1,
**caractérisé en ce**
**qu'**entre la première couche (10) et la première couche intermédiaire (16) jouxtant la deuxième couche (12), s'étend la deuxième couche intermédiaire (14) qui est dopée avec le matériau de la deuxième couche et jusqu'à laquelle s'étend le contact électroconducteur (15, 15a, 15b) contenant le matériau brasable ou mouillable par métal.

3. Composant à semi-conducteurs selon la revendication 1 ou 2,
**caractérisé en ce**
**que** la deuxième couche (12) est ou contient au moins un matériau de contact de base du groupe Al, In, Ga, B ou un mélange de matériaux dudit groupe, et/ou est constituée au moins par zones d'un mélange d'Al et du matériau brasable ou mouillable par métal, ou que la deuxième couche (12) est constituée d'un matériau fabriqué à partir d'un mélange d'Al et du matériau brasable ou mouillable par métal.

4. Composant à semi-conducteurs selon au moins une des revendications précédentes,
**caractérisé en ce**
**que** le matériau brasable ou mouillable par métal, qui est ou contient de préférence au moins un matériau du groupe Sn, Pb, In, Ga, Cd, Fe, Ag, Au, Ti, Hf, Zn, Mg, Ca, Ba, du matériau de brasage ou un mélange de matériaux dudit groupe, est après formation de la deuxième couche (12) incorporé par alliage dans cette dernière ou que le matériau brasable ou mouillable par métal est incorporé par alliage dans la deuxième couche intermédiaire (14) formant un champ répulsif face arrière (Back-Surface-Field) et constituée du matériau semi-conducteur allié au matériau de contact de base de la deuxième couche (12).

5. Composant à semi-conducteurs selon au moins une des revendications précédentes,
**caractérisé en ce**
**que** dans la deuxième couche intermédiaire (14) formée à partir de la première couche (10) sont dissous du matériau de contact de base de la deuxième couche (12) ainsi que du matériau brasable ou mouillable par métal.

6. Composant à semi-conducteurs selon au moins une des revendications précédentes,
**caractérisé en ce**
**que** la deuxième couche (12) contient entre 0,01 % en poids et 99,9 % en poids, en particulier entre 10 % en poids et 50 % en poids de matériau brasable ou mouillable par métal tel que de l'étain ou un alliage à l'étain.

7. Procédé pour fabriquer un contact métal-semi-conducteur (15, 15a, 15b) d'un composant à semi-conducteurs, tel qu'une cellule solaire, comprenant une première couche (10), telle qu'un substrat, constituée d'un matériau semi-conducteur, ainsi que d'une deuxième couche poreuse (12) appliquée sur la première couche et constituée d'un matériau de contact de base en métal ou contenant du métal, sachant
qu'après formation de la deuxième couche (12) est appliqué en totalité ou partiellement sur la face arrière du composant à semi-conducteurs un matériau brasable ou mouillable par métal (20) dans la zone des points de contact à former sur la deuxième couche, ou que pour former la deuxième couche est appliqué sur la première couche (10) un mélange du deuxième matériau et d'un matériau brasable ou mouillable par métal, et que par traitement mécanique et/ou traitement thermique et/ou projection thermique du matériau brasable ou mouillable par métal, du matériau brasable ou mouillable par métal est incorporé par alliage dans la deuxième couche et dans au moins une couche intermédiaire (14, 16, 18) qui se forme entre la première et la deuxième couches pendant la fabrication du composant à semi-conducteurs.

8. Procédé selon la revendication 7,
**caractérisé en ce**
**que** le matériau brasable ou mouillable par métal est incorporé par alliage dans la deuxième couche ou dans la deuxième couche (12) et dans l'au moins une couche intermédiaire (14, 16, 18) pendant et/ou après formation de la deuxième couche (12) exclusivement ou pour l'essentiel exclusivement par traitement thermique du composant à semi-conducteurs à fabriquer, sachant que de préférence le traitement thermique est effectué sous une température T telle que 150 °C ≤ T ≤ 800 °C, en particulier 230 °C ≤ T ≤ 600 °C.

9. Procédé selon la revendication 7,
**caractérisé en ce**
**que** par traitement acousto-mécanique, le matériau brasable ou mouillable par métal est incorporé par alliage dans la deuxième couche ou dans la deuxième couche (12) et dans l'au moins une couche intermédiaire (14, 16, 18).

10. Procédé selon l'une des revendications 7 à 9 précédentes,
**caractérisé en ce**
**que** pendant et/ou après formation de la deuxième couche (12), le matériau brasable ou mouillable par métal du composant à semi-conducteurs à fabriquer est incorporé par alliage jusque dans la deuxième couche ou dans la deuxième couche et l'au moins une couche intermédiaire (14, 16, 18), sachant qu'en particulier l'exposition aux ultrasons est effectuée sous une fréquence f telle que 10 kHz ≤ f ≤ 100 kHz, en particulier 20 kHz ≤ f ≤ 80 kHz, de préférence 20 kHz ou 40 kHz, et que de préférence pendant l'exposition aux ultrasons, le composant à semi-conducteurs à fabriquer est exposé à une température T telle que 0 °C ≤ T ≤ 1000 °C, en particulier 20 °C ≤ T ≤ 600 °C.

11. Procédé selon l'une des revendications 7 à 10 précédentes,
**caractérisé en ce**
**que** le matériau brasable est appliqué sur la deuxième couche (12) par projection thermique, sachant en particulier que le matériau brasable ou mouillable par métal est appliqué à une vitesse v telle que 10 m/s ≤ v ≤ 3000 m/s, de préférence v ≈ 300 m/s, que de préférence pendant la projection thermique, le composant à semi-conducteurs à fabriquer est exposé à une température T telle que 0 °C ≤ T ≤ 500 °C, de préférence 20 °C ≤ T ≤ 600 °C, et/ou que pendant la projection thermique, le composant à semi-conducteurs est soumis à des ultrasons d'une fréquence f telle qu'en particulier 10 kHz ≤ f ≤ 100 kHz, de préférence 20 kHz ≤ f ≤ 80 kHz, 20 kHz ou 40 kHz étant particulièrement privilégiées.

12. Procédé selon l'une des revendications 7 à 11 précédentes,
**caractérisé en ce**
**que** sur la première couche (10) sont appliqués un mélange constitué du matériau de contact de base de la deuxième couche (12), tel que de la pâte d'Al, et du matériau brasable ou mouillable par métal ou un alliage contenant le matériau brasable ou mouillable par métal, et qu'ensuite est formée la deuxième couche (12), sachant qu'en particulier est utilisé un mélange dont la part x en matériau brasable ou mouillable par métal ou en alliage contenant le matériau brasable est telle que 0 % en poids < x ≤ 50 % en poids ou 50 % en poids ≤ x < 100 % en poids.

13. Procédé selon l'une des revendications 7 à 12 précédentes,
**caractérisé en ce**
**que** le matériau brasable ou mouillable par métal est incorporé par alliage par exposition ponctuelle de la deuxième couche (12) à des températures élevées, en particulier par brasage dans la deuxième couche ou dans la deuxième couche jusqu'à au moins la couche intermédiaire.

14. Procédé selon l'une des revendications 7 à 13 précédentes,
**caractérisé en ce**
**qu'**en tant que matériau de contact de base pour la deuxième couche (12) est utilisé un matériau qui est ou contient au moins un matériau du groupe Al, In, Ga, B ou un mélange de matériaux dudit groupe, et/ou qu'en tant que matériau brasable ou mouillable par métal est utilisé un matériau qui est ou contient au moins un matériau du groupe Sn, In, Pb, Ga, Ag, Au, Cd, Fe, Ti, Hf, Zn, Mg, Ca, Ba ou un mélange de matériaux dudit groupe, sachant en particulier qu'en tant que matériau brasable ou mouillable par métal est utilisé un alliage à l'étain ou un matériau en contenant.

15. Procédé selon l'une des revendications 7 à 14 précédentes,
**caractérisé en ce**
**qu'**entre la première couche (10) et la deuxième couche (12) sont formés d'une part une première couche intermédiaire (16), qui est une couche de la deuxième couche alliée au matériau de la première couche, et d'autre part une deuxième couche intermédiaire (14), qui est une couche de la première couche alliée au matériau de la deuxième couche, ainsi qu'un système eutectique (18) s'étendant entre la première couche intermédiaire et la deuxième couche intermédiaire.
